# EUROPÄISCHE PATENTANMELDUNG

(11) **EP 3 664 582 A1**
(43) Veröffentlichungstag der Anmeldung: **10.06.2020**
(21) Anmeldenummer: 19213510.1
(22) Anmeldetag: 04.12.2019
(51) Int. Cl.: H05B 45/54, H05B 45/58

(54) **VERFAHREN ZUR ERKENNUNG EINES KURZSCHLUSSES IN EINEM LEUCHTMITTEL EINES FAHRZEUGS**

(30) Priorität: 07.12.2018 DE 102018131270
(71) Anmelder: HELLA GMBH & CO. KGAA, 59552 Lippstadt (DE)
(72) Erfinder: FELDGEN, Michael, 59555 Lippstadt (DE)

(57) **Zusammenfassung**

Die vorliegende Erfindung betrifft eine Schaltungsanordnung (1) zur Erkennung eines Kurzschlusses in wenigstens einer Leuchtdiode (2, 3, 4, 5) einer Leuchteinheit (6) eines Fahrzeugs (12), die mehrere in Reihe geschaltete Leuchtdioden (2, 3, 4, 5) umfasst, aufweisend eine Referenz-Leuchtdiode (7), eine Spannungsermittlungseinheit (8) zur Ermittlung einer Referenzspannung (U1) an der Referenz-Leuchtdiode (7) sowie jeweils einer Diodenspannung (U2, U3, U4, U5) an einer der Leuchtdioden (2, 3, 4, 5) der Leuchteinheit (6), und eine Erkennungseinheit (9) zur Erkennung eines Kurzschlusses in einer Leuchtdiode (2, 3, 4, 5) anhand der Referenzspannung (U1) und einer einzelnen Diodenspannung (U2, U3, U4, U5), wobei die Referenz-Leuchtdiode (7) und die Leuchtdioden (2, 3, 4, 5) die gleichen Leuchtdioden sind. Ferner betrifft die Erfindung ein entsprechendes Verfahren zur Erkennung eines Kurzschlusses, ein Computerprogramm (13), ein Speichermittel sowie ein Fahrzeug (12).

## Beschreibung

Die vorliegende Erfindung betrifft eine Schaltungsanordnung sowie ein Verfahren zum Erkennen eines Kurzschlusses in einer Leuchtdiode. Zudem betrifft die Erfindung ein Computerprogramm zum Erkennen eines Kurzschlusses in einer Leuchtdiode, ein Speichermittel mit einem darauf gespeicherten Computerprogramm sowie ein Fahrzeug, in welchem ein Kurzschluss in einer Leuchtdiode erkannt werden kann.

Die Komplexität von Lichtschaltungen im Automobilbereich nimmt ständig zu. Aktuelle Beleuchtungssysteme sind nicht mehr auf einzelne Leuchtmittel beschränkt, sondern weisen häufig mehrere Leuchtmittel auf, die beispielsweise in Form von mehreren in Reihe geschalteten Leuchtdioden die erforderliche oder gewünschte Leuchtwirkung erzielen. D.h., zur Erzeugung der gewünschten Lichtfunktion werden mittlerweile mehrere Leuchtdioden zueinander in Reihe geschaltet und über eine Konstantstromquelle mit einer gemeinsamen Versorgungsspannung versorgt.

Wie in der deutschen Patentanmeldung DE 10 2008 008 217 A1 beschrieben, kommt ein Ausfall von Leuchtmitteln in Fahrzeugscheinwerfern bzw. Lichteinheiten für Kraftfahrzeuge üblicherweise durch Unterbrechung zu Stande, etwa bei Lampen mit einem Glühfaden. Auch bei der Verwendung von Leuchtdioden als Lichtquellen liegt in der Regel bei einem Ausfall von einer oder mehreren Leuchtdioden eine Unterbrechung vor. Mit geringerer Wahrscheinlichkeit kann aber auch ein Kurzschluss von einer oder mehreren Leuchtdioden vorliegen.

Von Seiten der Automobilindustrie wird gefordert, auch den Kurzschluss eines einzelnen Leuchtmittels detektieren zu können. Durch große Spannungstoleranzen ist es bei einer Reihenschaltung von mehreren Leuchtdioden bei gattungsgemäßen Schaltungsanordnungen allerdings nur schwer und mit entsprechend großem Aufwand, d. h., nur mittels aufwändiger Elektronik, möglich, einen Kurzschluss von einer einzigen Leuchtdiode durch Gesamtspannungsüberwachung einer Reihenschaltung der Leuchtdioden zu erfassen. Ein gattungsgemäßes Verfahren zur Ermittlung eines Kurzschlusses kann beispielsweise der DE 10 2014 112 176 A1 entnommen werden.

Gemäß der DE 10 2008 008 217 A1 wird eine Schaltungsanordnung zur Erkennung eines Kurzschlusses von einer oder mehreren Leuchtdioden vorgeschlagen, wobei zwei oder mehr Leuchtdioden zur Realisierung von zumindest einer Lichtfunktion für einen Scheinwerfer bzw. eine Lichteinheit eines Kraftfahrzeuges vorgesehen sind, und die Leuchtdioden zueinander in Reihe geschaltet sind und über eine Konstantstromquelle an einer Versorgungsspannungsquelle liegen. Gemäß der DE 10 2008 008 217 A1 ist jeder Leuchtdiode ein elektronischer Schalter zugeordnet. Wobei weiterhin eine an den Leuchtdioden abfallende Spannung einem Steuereingang des der jeweiligen Leuchtdiode zugeordneten Schalters zugeführt ist, und wobei der Schalter von einem Offenzustand/Schließzustand im Normalbetrieb der zugeordneten Leuchtdiode in einen Schließzustand/Offenzustand im Kurzschlussfall der Leuchtdiode übergeht und die sich dadurch ergebende Änderung des Spannungsabfalls detektierbar ist.

Mit Blick auf den verfügbaren Stand der Technik besteht jedoch weiterhin der Wunsch, nach einem noch einfacheren und/oder genauer arbeitenden System zur Erkennung eines Kurzschlusses in einer Leuchtdiode einer gattungsgemäßen Leuchteinheit.

Mithin ist es Aufgabe der vorliegenden Erfindung, eine Schaltungsanordnung zu schaffen, mittels welcher auf einfache und zuverlässige Weise ein Kurzschluss einer Leuchtdiode in einer Leuchteinheit mit mehreren, in Reihe geschalteten Leuchtdioden erkannt werden kann. Ferner ist es Aufgabe der Erfindung, ein entsprechendes Verfahren und ein Computerprogrammprodukt zur einfachen und zuverlässigen Erkennung eines Kurzschlusses in einer Leuchtdiode in einer solchen Leuchteinheit bereitzustellen. Darüber hinaus ist es Aufgabe der Erfindung, ein Speichermittel, auf welchem ein solches Computerprogrammprodukt gespeichert ist, sowie ein Fahrzeug mit einer darin ausgestalteten Schaltungsanordnung, zur einfachen und zuverlässigen Erkennung eines Kurzschlusses in einer Leuchtdiode einer Reihenschaltung mit mehreren Leuchtdioden, zu finden.

Die voranstehende Aufgabe wird durch die Patentansprüche gelöst. Insbesondere wird die voranstehende Aufgabe durch die Schaltungsanordnung gemäß Anspruch 1, das Verfahren gemäß Anspruch 5, das Computerprogrammprodukt gemäß Anspruch 11, das Speichermittel gemäß Anspruch 12 sowie das Fahrzeug gemäß Anspruch 13 gelöst. Weitere Vorteile der Erfindung ergeben sich aus den Unteransprüchen, der Beschreibung und den Figuren. Dabei gelten Merkmale, die im Zusammenhang mit der Schaltungsanordnung beschrieben sind, selbstverständlich auch im Zusammenhang mit dem erfindungsgemäßen Verfahren, dem erfindungsgemäßen Computerprogramm, dem erfindungsgemäßen Speichermittel, dem erfindungsgemäßen Fahrzeug und jeweils umgekehrt, sodass bezüglich der Offenbarung zu den einzelnen Erfindungsaspekten stets wechselseitig Bezug genommen wird bzw. werden kann.

Gemäß einem ersten Aspekt der vorliegenden Erfindung wird eine Schaltungsanordnung zur Erkennung eines Kurzschlusses in wenigstens einer Leuchtdiode einer Leuchteinheit eines Fahrzeugs, die mehrere in Reihe geschaltete Leuchtdioden umfasst, zur Verfügung gestellt. Die Schaltungsanordnung weist eine Referenz-Leuchtdiode und eine Spannungsermittlungseinheit zur Ermittlung einer Referenzspannung an der Referenz-Leuchtdiode sowie jeweils einer Diodenspannung an einer der Leuchtdioden der Leuchteinheit auf. Außerdem weist die Schaltungsanordnung eine Erkennungseinheit zur Erkennung eines Kurzschlusses in einer Leuchtdiode anhand der Referenzspannung und einer einzelnen Diodenspannung auf, wobei die Referenz-Leuchtdiode und die Leuchtdioden die gleichen Leuchtdioden sind.

Mit Hilfe der erfindungsgemäßen Schaltungsanordnung, insbesondere mit Hilfe der Referenz-Leuchtdiode, kann ein Kurzschluss in einer Leuchtdiode einfach und zuverlässig festgestellt bzw. ermittelt werden. Anhand der Referenzspannung und einer zugehörigen Diodenspannung kann auf einfache Weise festgestellt werden, ob an der entsprechenden Leuchtdiode ein Kurzschluss vorliegt oder nicht. Beträgt die Referenzspannung beispielsweise 3V und die zugehörige Diodenspannung ebenfalls 3V, kann davon ausgegangen werden, dass kein Kurzschluss vorliegt. Beträgt die Referenzspannung 3V und die zugehörige Diodenspannung ist deutlich geringer, durchlassspannungstypisch ca. 10% von 3V, kann davon ausgegangen werden, dass ein Kurzschluss vorliegt. Demnach könnte die Erkennungseinheit zur Erkennung eines Kurzschlusses anhand eines Vergleichs zwischen der Referenzspannung und der Diodenspannung konfiguriert und ausgestaltet sein. Der Vergleich kann eine Subtraktion oder einer Addition zwischen der Referenzspannung und der einen Diodenspannung umfassen.

Durch die vorgeschlagene Schaltungsanordnung kann nicht nur festgestellt werden, ob an einer der Leuchtdioden der Leuchteinheit ein Kurzschluss vorliegt, sondern auch an welcher der Leuchtdioden der Kurzschluss vorliegt.

Die Referenz-Leuchtdiode ist vorzugsweise eine Leuchtdiode, die in der Schaltungsanordnung und/oder im Fahrzeug nicht als Leuchtmittel, sondern ausschließlich als Referenzwertgeber zur Bereitstellung der Referenzspannung verwendet wird. Bei der Ermittlung der Referenzspannung wird die Referenz-Leuchtdiode gegen Masse gemessen. Bei der Ermittlung der Diodenspannung wird jeweils eine Leuchtdiode gegen Masse gemessen. Die Leuchtdioden sind in verschiedenen Kanälen angeordnet. D.h., es wird jeweils eine spezifische Diodenspannung an einer spezifischen Leuchtdiode in einem spezifischen Kanal ermittelt. Mit anderen Worten, jede Leuchtdiode, deren Diodenspannung ermittelt wird, befindet sich in einem anderen Kanal. Unter der Diodenspannung kann eine Durchlassspannung an einer der Leuchtdioden verstanden werden.

Darunter, dass die Referenz-Leuchtdiode und die Leuchtdioden die gleichen Leuchtdioden sind kann verstanden werden, dass die Referenz-Leuchtdiode vom gleichen Typ wie die Leuchtdioden, die auf einen möglichen Kurzschluss überprüft werden, ist.

Gemäß einer weiteren Ausführungsform der vorliegenden Erfindung ist es möglich, dass bei einer Schaltungsanordnung die Erkennungseinheit konfiguriert und ausgestaltet ist, die Referenzspannung jeweils mit einer der Diodenspannungen zu vergleichen, basierend auf dem Vergleich jeweils eine Differenzspannung zwischen der Referenzspannung und der jeweiligen Diodenspannung zu ermitteln, die ermittelte Differenzspannung jeweils mit einer vordefinierbaren Schwellenspannung zu vergleichen und einen Kurzschluss in einer Leuchtdiode zu erkennen, wenn die Differenzspannung größer als der Schwellenwert ist. Anhand der Differenzspannung in Relation zum Schwellenwert lässt sich auf einfache und eindeutige Weise sowie mit einfachen Rechenschritten und entsprechend schnell erkennen, ob an einer der Leuchtdioden ein Kurzschluss vorliegt oder nicht.

Ferner ist es bei einer erfindungsgemäßen Schaltungsanordnung möglich, dass die Schaltungsanordnung eine Abschalteinheit zum Abschalten, insbesondere zum automatischen Abschalten der Leuchteinheit anhand der Referenzspannung und einer einzelnen Diodenspannung aufweist. Durch die Abschalteinheit kann verhindert werden, dass durch einen Kurzschluss in einer Leuchtdiode noch weitere Leuchtdioden und/oder weitere Bauteile der Schaltungsanordnung oder des Fahrzeugs beschädigt oder zerstört werden. Hinsichtlich der Verwendung der Referenzspannung und der einzelnen Diodenspannung gilt das vorstehend zur Erkennung des Kurzschlusses geschriebene in analoger Weise.

Zusätzlich oder alternativ ist es möglich, dass bei einer Schaltungsanordnung gemäß der vorliegenden Erfindung eine Signalausgabeeinheit zur Ausgabe eines Warnsignals zum Abschalten der Leuchteinheit anhand der Referenzspannung und einer einzelnen Diodenspannung bereitgestellt ist. Durch das Warnsignal zum Abschalten der Leuchteinheit bzw. die Empfehlung zum Abschalten der Leuchteinheit kann ein Nutzer des Fahrzeugs rechtzeitig eine Reparatur oder einen Austausch der Leuchteinheit veranlassen, bevor die Leuchteinheit ggf. in einer ungünstigen Situation ganz ausfällt. Die Signalausgabeeinheit kann konfiguriert und ausgestaltet sein, das Warnsignal an einen Signalwandler der Schaltungsanordnung oder des Fahrzeugs zur akustischen und/oder optischen Ausgabe des Warnsignals an den Nutzer des Fahrzeugs bzw. der Schaltungsanordnung zu senden.

Gemäß einem weiteren Aspekt der vorliegenden Erfindung wird ein Verfahren zur Erkennung eines Kurzschlusses in wenigstens einer Leuchtdiode einer Leuchteinheit eines Fahrzeugs, die mehrere in Reihe geschaltete Leuchtdioden umfasst, mittels einer Referenz-Leuchtdiode, bereitgestellt, wobei die Referenz-Leuchtdiode und die Leuchtdioden die gleichen bzw. die gleiche Art Leuchtdioden sind. Das Verfahren weist die folgenden Schritte auf:
- Ermitteln einer Referenzspannung an der Referenz-Leuchtdiode der Schaltungsanordnung sowie jeweils einer Diodenspannung an einer der Leuchtdioden der Leuchteinheit durch die Spannungsermittlungseinheit, und
- Erkennen eines Kurzschlusses in einer Leuchtdiode anhand der Referenzspannung und einer einzelnen Diodenspannung.

Damit bringt das erfindungsgemäße Verfahren die gleichen Vorteile mit sich, wie sie ausführlich mit Bezug auf die erfindungsgemäße Schaltungsanordnung beschrieben worden sind.

Weiterhin kann ein erfindungsgemäßes Verfahren die folgenden Schritte aufweisen:
- Vergleichen der Referenzspannung mit jeweils einer der Diodenspannungen,
- Ermitteln jeweils einer Differenzspannung zwischen der Referenzspannung und der jeweiligen Diodenspannung basierend auf dem Vergleich,
- Vergleichen der ermittelten Differenzspannung mit jeweils einer vordefinierbaren Schwellenspannung, und
- Erkennen eines Kurzschlusses in einer Leuchtdiode, wenn die Differenzspannung größer als der Schwellenwert ist.

Zur Erkennung des Kurzschlusses kann die Referenzspannung jeweils mit einer der Diodenspannungen verglichen werden, wobei die Ermittlung der Referenzspannung und einer Diodenspannung sowie der zugehörige Vergleich zwischen der Referenzspannung und der Diodenspannungen zusammen über eine Zeit von weniger als 100ms, insbesondere weniger als 10ms, durchgeführt wird. Dadurch können eine Eigenerwärmung und eine damit verbundene Temperaturdrift der Leuchtdioden verhindert oder zumindest im Wesentlichen verhindert werden.

Wie vorstehend bereits zur Schaltungsanordnung beschrieben, ist es im Rahmen des Verfahrens weiterhin möglich, dass die Leuchteinheit in Form eines Fahrzeugscheinwerfers eines Fahrzeugs ausgestaltet ist, wobei das Ermitteln der Referenzspannung, das Ermitteln der Diodenspannungen und das Erkennen eines möglichen Kurzschlusses während eines Starts des Fahrzeugs durchgeführt werden. Die Leuchteinheit kann entsprechend anhand der Referenzspannung und einer einzelnen Diodenspannung durch eine Abschalteinheit abgeschaltet werden. Anhand der Referenzspannung und einer einzelnen Diodenspannung kann ein Warnsignal zum Abschalten der Leuchteinheit durch eine Signalausgabeeinheit ausgegeben werden.

Gemäß einem weiteren Aspekt der Erfindung wird ein Computerprogramm bereitgestellt, das Befehle umfasst, die bei der Ausführung des Computerprogramms durch einen Computer diesen veranlassen, das vorstehend beschriebene Verfahren durchzuführen. Das Computerprogramm kann als computerlesbarer Anweisungscode in jeder geeigneten Programmiersprache wie beispielsweise in JAVA, C++ oder C# implementiert sein. Das Computerprogramm kann auf einem computerlesbaren Speichermedium wie einer Datendisk, einem Wechsellaufwerk, einem flüchtigen oder nichtflüchtigen Speicher, oder einem eingebauten Speicher/Prozessor abgespeichert sein. Der Anweisungscode kann einen Computer oder andere programmierbare Geräte wie ein Fahrzeugsteuergerät derart programmieren, dass die gewünschten Funktionen ausgeführt werden. Ferner kann das Computerprogramm in einem Netzwerk wie beispielsweise dem Internet bereitgestellt werden bzw. sein, von dem es bei Bedarf von einem Nutzer heruntergeladen werden kann. Das Computerprogramm kann sowohl mittels einer Software, als auch mittels einer oder mehrerer spezieller elektronischer Schaltungen, d.h. in Hardware in Form eines Computerprogrammprodukts, oder in beliebig hybrider Form, d.h. mittels Software-Komponenten und Hardware-Komponenten, realisiert werden bzw. sein.

Zudem wird ein Speichermittel mit einem solchen Computerprogramm, das auf dem Speichermittel gespeichert ist, zur Verfügung gestellt. Das Speichermittel kann als Datenträger in Form eines Speicherstifts, einer Speicherdisc, einer Festplatte oder aber auch eines Steuergerätes oder dergleichen ausgestaltet sein. Darüber hinaus umfasst die vorliegende Erfindung ein Fahrzeug mit wenigstens einer Leuchteinheit und einer wie vorstehend beschriebenen Schaltungsanordnung, die zur Erkennung eines Kurzschlusses in wenigstens einer Leuchtdiode der Leuchteinheit, die mehrere in Reihe geschaltete Leuchtdioden umfasst, konfiguriert und ausgestaltet ist, wobei die Leuchteinheit in Form eines Fahrzeugscheinwerfers ausgestaltet ist. Die Leuchteinheit ist insbesondere als Abblendlicht des Fahrzeugs ausgestaltet.

Damit bringen das erfindungsgemäße Computerprogramm, das erfindungsgemäße Speichermittel sowie das erfindungsgemäße Fahrzeug ebenfalls die vorstehend beschriebenen Vorteile mit sich.

Weitere, die Erfindung verbessernde Maßnahmen ergeben sich aus der nachfolgenden Beschreibung zu verschiedenen Ausführungsbeispielen der Erfindung, welche in den Figuren schematisch dargestellt sind. Sämtliche aus den Ansprüchen, der Beschreibung oder den Figuren hervorgehende Merkmale und/oder Vorteile, einschließlich konstruktiver Einzelheiten und räumlicher Anordnungen können sowohl für sich als auch in den verschiedenen Kombinationen erfindungswesentlich sein.

Anhand der beigefügten Zeichnungen wird die Erfindung nachfolgend näher erläutert. Dabei zeigt:
- Fig. 1: eine Schaltungsanordnung gemäß einer bevorzugten Ausführungsform der vorliegenden Erfindung,
- Fig. 2: ein Fahrzeug mit einer wie in Fig. 1 dargestellten Schaltungsanordnung,
- Fig. 3: ein Flussdiagramm zum Erläutern eines Verfahrens gemäß einer bevorzugten Ausführungsform der vorliegenden Erfindung, und
- Fig. 4: einen Licht-Matrix-Manager mit einer wie in Fig. 1 dargestellten Schaltungsanordnung.

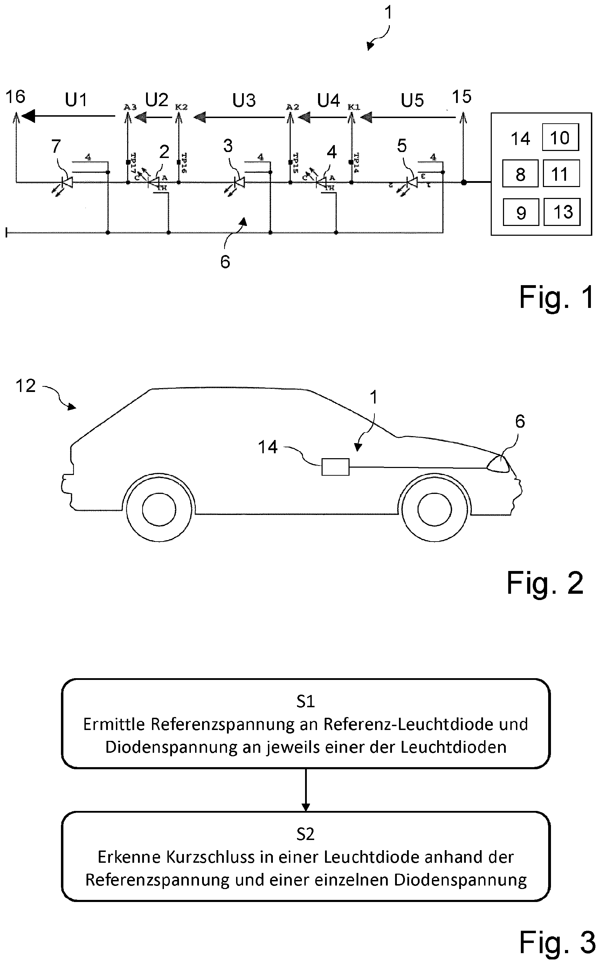

Elemente mit gleicher Funktion und Wirkungsweise sind in den Figuren 1 bis 4 jeweils mit denselben Bezugszeichen versehen.

Fig. 1 zeigt eine Schaltungsanordnung 1 zur Erkennung eines Kurzschlusses in wenigstens einer Leuchtdiode 2, 3, 4, 5 einer Leuchteinheit 6, die mehrere in Reihe geschaltete Leuchtdioden 2, 3, 4, 5 umfasst. Die Schaltungsanordnung 1 weist ferner eine Referenz-Leuchtdiode 7 und eine Spannungsermittlungseinheit 8 zur Ermittlung einer Referenzspannung U1 an der Referenz-Leuchtdiode 7 sowie jeweils einer Diodenspannung U2, U3, U4, U5 an einer der Leuchtdioden 2, 3, 4, 5 der Leuchteinheit 6 auf. D.h., die Spannungsermittlungseinheit ist zur Ermittlung einer Diodenspannung U2 an einer ersten Leuchtdiode 2, einer Diodenspannung U3 an einer zweiten Leuchtdiode 3, einer Diodenspannung U4 an einer dritten Leuchtdiode 4 und einer Diodenspannung U5 an einer vierten Leuchtdiode 5 ausgestaltet. Außerdem weist die Schaltungsanordnung 1 eine Erkennungseinheit 9 zur Erkennung eines Kurzschlusses in wenigstens einer der Leuchtdioden 2, 3, 4, 5 anhand der Referenzspannung U1 und einer einzelnen Diodenspannung U2, U3, U4, U5 auf. Die Referenz-Leuchtdiode 7 und die Leuchtdioden 2, 3, 4, 5 die gleiche Leuchtdioden bzw. die Referenz-Leuchtdiode 7 ist von der gleichen Art wie die zu überprüfenden Leuchtdioden 2, 3, 4, 5.

Die in Fig. 1 dargestellte Erkennungseinheit 9 ist konfiguriert und ausgestaltet, die Referenzspannung U1 jeweils mit einer der Diodenspannungen U2, U3, U4, U5 zu vergleichen, basierend auf dem Vergleich jeweils eine Differenzspannung zwischen der Referenzspannung U1 und der jeweiligen Diodenspannung U2, U3, U4, U5 zu ermitteln, die ermittelte Differenzspannung jeweils mit einer vordefinierbaren Schwellenspannung oder einem entsprechenden Schwellenwert zu vergleichen und einen Kurzschluss in einer Leuchtdiode 2, 3, 4, 5 zu erkennen, wenn die Differenzspannung größer als der Schwellenwert ist.

Die Schaltungsanordnung 1 weist ferner eine Abschalteinheit 10 zum Abschalten der Leuchteinheit 6 anhand der Referenzspannung U1 und einer einzelnen Diodenspannung U2, U3, U4, U5 auf. Ferner weist die Schaltungsanordnung 1 eine Signalausgabeeinheit 11 zur Ausgabe eines Warnsignals zum Abschalten der Leuchteinheit 2 anhand der Referenzspannung U1 und einer einzelnen Diodenspannung U2, U3, U4, U5 auf.

Gemäß der in Fig. 1 dargestellten Schaltungsanordnung 1 sind die Spannungsermittlungseinheit 8, die Erkennungseinheit 9, die Abschalteinheit 10 und die Signalausgabeeinheit 11 in ein Steuergerät 14 in Form eines Fahrzeugsteuergeräts integriert, in welchem ferner ein Computerprogramm 13 zur Ausführung eines später mit Bezug auf Fig. 3 beschriebenen Verfahrens installiert ist. Die in Fig. 1 dargestellte Schaltungsanordnung 1 steht mit einer Anode 15 und einer Kathode 16 in Signalverbindung.

In Fig. 2 ist ein Fahrzeug 12 mit einem Steuergerät 14 und zwei Leuchteinheiten 6 in Form von zwei Fahrzeugscheinwerfern dargestellt. Das Fahrzeug weist eine wie vorstehend beschriebene Schaltungsanordnung 1 auf, die zur Erkennung eines Kurzschlusses in wenigstens einer Leuchtdiode 2, 3, 4, 5 einer der Leuchteinheiten 6 konfiguriert und ausgestaltet ist.

In Fig. 3 ist ein Flussdiagramm zum Erläutern eines Verfahrens zur Erkennung eines Kurzschlusses in wenigstens einer der Leuchtdioden 2, 3, 4, 5 der Leuchteinheit 6 gemäß einer bevorzugten Ausführungsform dargestellt. Hierzu wird in einem ersten Schritt S1 eine Referenzspannung U1 an der Referenz-Leuchtdiode 7 der Schaltungsanordnung 1 sowie jeweils einer Diodenspannung U2, U3, U4, U5 an einer der Leuchtdioden 2, 3, 4, 5 der Leuchteinheit 6 durch die Spannungsermittlungseinheit 8 ermittelt. Anschließend kann in einem zweiten Schritt S2 ein Kurzschluss in einer der Leuchtdioden 2, 3, 4, 5 anhand der Referenzspannung U1 und einer einzelnen Diodenspannung U2, U3, U4, U5 erkannt werden.

Gemäß einer bevorzugten Ausführungsform werden hierzu die Referenzspannung U1 mit jeweils einer der Diodenspannungen U2, U3, U4, U5 verglichen, jeweils eine Differenzspannung zwischen der Referenzspannung U1 und der jeweiligen Diodenspannung U2, U3, U4, U5 basierend auf dem Vergleich ermittelt, die ermittelte Differenzspannung mit jeweils einer vordefinierbaren Schwellenspannung verglichen, und ein Kurzschluss in einer Leuchtdiode 2, 3, 4, 5 erkannt, wenn die Differenzspannung größer als der Schwellenwert ist.

Die Ermittlung der Referenzspannung U1 und einer Diodenspannung U2, U3, U4, U5 sowie der zugehörige Vergleich zwischen der Referenzspannung U1 und der Diodenspannungen U2, U3, U4, U5 werden zusammen über eine Zeit von weniger als 100ms durchgeführt. Das Ermitteln der Referenzspannung U1, das Ermitteln der Diodenspannungen U2, U3, U4, U5 und das Erkennen eines möglichen Kurzschlusses werden während eines Starts des Fahrzeugs 12 durchgeführt.

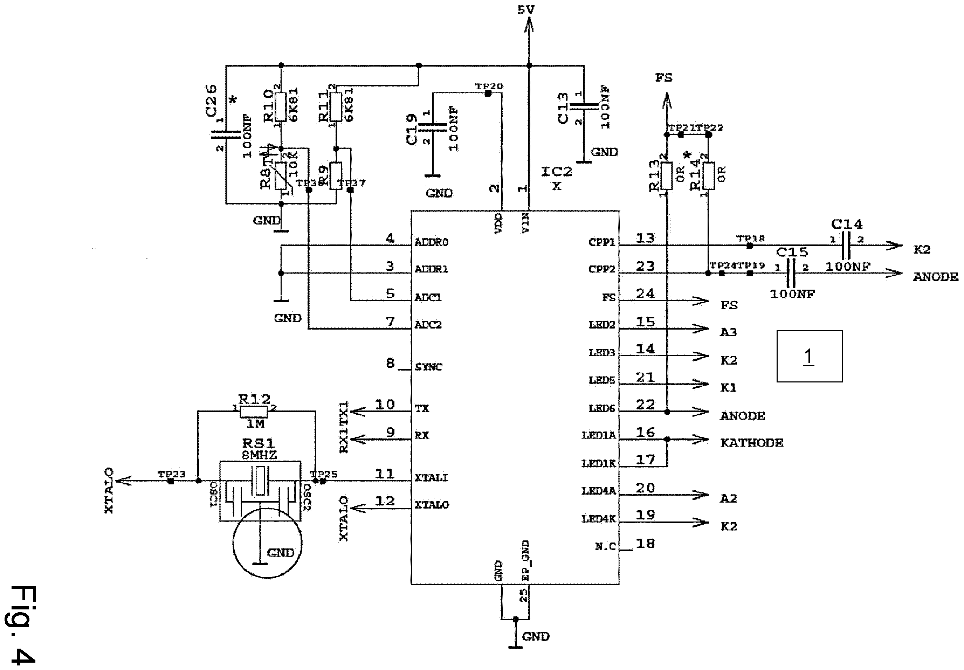

Fig. 4 zeigt einen Licht-Matrix-Manager mit einer darin integrierten Schaltungsanordnung 1, wie sie vorstehend im Detail beschrieben worden ist.

Die Erfindung lässt neben den dargestellten Ausführungsformen weitere Gestaltungsgrundsätze zu. D.h., die Erfindung soll nicht auf die mit Bezug auf die Figuren erläuterten Ausführungsbeispiele beschränkt betrachtet werden.

### Bezugszeichenliste

- 1: Schaltungsanordnung
- 2: Leuchtdiode
- 3: Leuchtdiode
- 4: Leuchtdiode
- 5: Leuchtdiode
- 6: Leuchteinheit
- 7: Referenz-Leuchtdiode
- 8: Spannungsermittlungseinheit
- 9: Erkennungseinheit
- 10: Abschalteinheit
- 11: Signalausgabeeinheit
- 12: Fahrzeug
- 13: Computerprogrammprodukt
- 14: Steuergerät
- 15: Anode
- 16: Kathode

- U1: Referenzspannung
- U2: Diodenspannung
- U3: Diodenspannung
- U4: Diodenspannung
- U5: Diodenspannung

## Patentansprüche

1. Schaltungsanordnung (1) zur Erkennung eines Kurzschlusses in wenigstens einer Leuchtdiode (2, 3, 4, 5) einer Leuchteinheit (6) eines Fahrzeugs (12), die mehrere in Reihe geschaltete Leuchtdioden (2, 3, 4, 5) umfasst, aufweisend eine Referenz-Leuchtdiode (7), eine Spannungsermittlungseinheit (8) zur Ermittlung einer Referenzspannung (U1) an der Referenz-Leuchtdiode (7) sowie jeweils einer Diodenspannung (U2, U3, U4, U5) an einer der Leuchtdioden (2, 3, 4, 5) der Leuchteinheit (6), und eine Erkennungseinheit (9) zur Erkennung eines Kurzschlusses in einer Leuchtdiode (2, 3, 4, 5) anhand der Referenzspannung (U1) und einer einzelnen Diodenspannung (U2, U3, U4, U5), wobei die Referenz-Leuchtdiode (7) und die Leuchtdioden (2, 3, 4, 5) die gleichen Leuchtdioden sind.

2. Schaltungsanordnung (1) nach Anspruch 1,
**dadurch gekennzeichnet,**
**dass** die Erkennungseinheit (9) konfiguriert und ausgestaltet ist, die Referenzspannung (U1) jeweils mit einer der Diodenspannungen (U2, U3, U4, U5) zu vergleichen, basierend auf dem Vergleich jeweils eine Differenzspannung zwischen der Referenzspannung (U1) und der jeweiligen Diodenspannung (U2, U3, U4, U5) zu ermitteln, die ermittelte Differenzspannung jeweils mit einer vordefinierbaren Schwellenspannung zu vergleichen und einen Kurzschluss in einer Leuchtdiode (2, 3, 4, 5) zu erkennen, wenn die Differenzspannung größer als der Schwellenwert ist.

3. Schaltungsanordnung (1) nach einem der voranstehenden Ansprüche,
**dadurch gekennzeichnet**
**dass** die Schaltungsanordnung (1) eine Abschalteinheit (10) zum Abschalten der Leuchteinheit (6) anhand der Referenzspannung (U1) und einer einzelnen Diodenspannung (U2, U3, U4, U5) aufweist.

4. Schaltungsanordnung (1) nach einem der voranstehenden Ansprüche,
**dadurch gekennzeichnet,**
**dass** die Schaltungsanordnung (1) eine Signalausgabeeinheit (11) zur Ausgabe eines Warnsignals zum Abschalten der Leuchteinheit (2) anhand der Referenzspannung (U1) und einer einzelnen Diodenspannung (U2, U3, U4, U5) aufweist.

5. Verfahren zur Erkennung eines Kurzschlusses in wenigstens einer Leuchtdiode (2, 3, 4, 5) einer Leuchteinheit (6) eines Fahrzeugs (12), die mehrere in Reihe geschaltete Leuchtdioden (2, 3, 4, 5) umfasst, mittels einer Referenz-Leuchtdiode (7), wobei die Referenz-Leuchtdiode (7) und die Leuchtdioden (2, 3, 4, 5) die gleichen Leuchtdioden sind, aufweisend die Schritte:
- Ermitteln einer Referenzspannung (U1) an der Referenz-Leuchtdiode (7) der Schaltungsanordnung (1) sowie jeweils einer Diodenspannung (U2, U3, U4, U5) an einer der Leuchtdioden (2, 3, 4, 5) der Leuchteinheit (6) durch die Spannungsermittlungseinheit (8), und
- Erkennen eines Kurzschlusses in einer Leuchtdiode (2, 3, 4, 5) anhand der Referenzspannung (U1) und einer einzelnen Diodenspannung (U2, U3, U4, U5).

6. Verfahren nach Anspruch 5,
**gekennzeichnet durch** die Schritte:
- Vergleichen der Referenzspannung (U1) mit jeweils einer der Diodenspannungen (U2, U3, U4, U5),
- Ermitteln jeweils einer Differenzspannung zwischen der Referenzspannung (U1) und der jeweiligen Diodenspannung (U2, U3, U4, U5) basierend auf dem Vergleich,
- Vergleichen der ermittelten Differenzspannung mit jeweils einer vordefinierbaren Schwellenspannung, und
- Erkennen eines Kurzschlusses in einer Leuchtdiode (2, 3, 4, 5), wenn die Differenzspannung größer als der Schwellenwert ist.

7. Verfahren nach einem der Ansprüche 5 bis 6,
**dadurch gekennzeichnet,**
**dass** zur Erkennung des Kurzschlusses die Referenzspannung (U1) jeweils mit einer der Diodenspannungen (U2, U3, U4, U5) verglichen wird, wobei die Ermittlung der Referenzspannung (U1) und einer Diodenspannung (U2, U3, U4, U5) sowie der zugehörige Vergleich zwischen der Referenzspannung (U1) und der Diodenspannungen (U2, U3, U4, U5) zusammen über eine Zeit von weniger als 100ms durchgeführt wird.

8. Verfahren nach einem der Ansprüche 5 bis 7,
**dadurch gekennzeichnet,**
**dass** die Leuchteinheit (6) in Form eines Fahrzeugscheinwerfers eines Fahrzeugs (12) ausgestaltet ist, wobei das Ermitteln der Referenzspannung (U1), das Ermitteln der Diodenspannungen (U2, U3, U4, U5) und das Erkennen eines möglichen Kurzschlusses während eines Starts des Fahrzeugs (12) durchgeführt werden.

9. Verfahren nach einem der Ansprüche 5 bis 8,
**dadurch gekennzeichnet,**
**dass** die Leuchteinheit (6) anhand der Referenzspannung (U1) und einer einzelnen Diodenspannung (U2, U3, U4, U5) durch eine Abschalteinheit (10) abgeschaltet wird.

10. Verfahren nach einem der Ansprüche 5 bis 9,
**dadurch gekennzeichnet,**
**dass** anhand der Referenzspannung (U1) und einer einzelnen Diodenspannung (U2, U3, U4, U5) ein Warnsignal zum Abschalten der Leuchteinheit (6) durch eine Signalausgabeeinheit (11) ausgegeben wird.

11. Computerprogramm (13), umfassend Befehle, die bei der Ausführung des Computerprogramms (13) durch einen Computer diesen veranlassen, das Verfahren nach einem der Ansprüche 5 bis 10 durchzuführen.

12. Speichermittel mit einem darauf gespeicherten Computerprogramm (13) nach Anspruch 11.

13. Fahrzeug (12) mit wenigstens einer Leuchteinheit (6) und einer Schaltungsanordnung (1) nach einem der Ansprüche 1 bis 4, die zur Erkennung eines Kurzschlusses in wenigstens einer Leuchtdiode (2, 3, 4, 5) der Leuchteinheit (6), die mehrere in Reihe geschaltete Leuchtdioden (2, 3, 4, 5) umfasst, konfiguriert und ausgestaltet ist, wobei die Leuchteinheit (6) in Form eines Fahrzeugscheinwerfers ausgestaltet ist.
